# EUROPÄISCHE PATENTSCHRIFT

(11) **EP 2 981 837 B1**
(45) Veröffentlichungstag und Bekanntmachung des Hinweises auf die Patenterteilung: **26.01.2022**
(21) Anmeldenummer: 14716264.8
(22) Anmeldetag: 02.04.2014
(51) Int. Cl.: G01R 31/00, G01R 31/69, G01R 31/54

(54) **VORRICHTUNG UND VERFAHREN ZUR ÜBERWACHUNG EINER ANHÄNGERSCHLUSSDOSE**
DEVICE AND PROCEDURE FOR MONITORING A TRAILER ELECTRICITY CONNECTOR
APPAREIL ET PROCEDE DE SUIVI D'UN CONNECTEUR ELECTRIQUE D'UNE REMORQUE

(30) Priorität: 03.04.2013 DE 102013103307
(43) Veröffentlichungstag der Anmeldung: 10.02.2016
(73) Patentinhaber: HELLA GmbH & Co. KGaA, 59552 Lippstadt (DE)
(72) Erfinder: DOME, Juri, 97084 Würzburg (DE); SCHMÄLING, Jan, 97769 Bad Brückenau (DE)
(86) Internationale Anmeldenummer: PCT/EP2014/056566
(87) Internationale Veröffentlichungsnummer: WO 2014/161871

(56) Entgegenhaltungen:
- DE-A1- 10 006 490
- DE-A1- 10 212 685
- DE-A1- 19 950 851
- DE-A1-102005 028 184
- DE-A1-102011 101 467
- US-A- 3 103 808
- US-A- 4 547 722
- US-A- 4 866 390
- US-A1- 2010 176 830
- US-B1- 7 339 465
- US-B2- 7 319 304

## Beschreibung

Die Erfindung betrifft eine Vorrichtung zur Überwachung einer Anhängeranschlussdose eines Fahrzeugs, an welcher das Bordnetz eines Fahrzeuganhängers anschließbar ist.

Um mit einem, an ein Zugfahrzeug angehängten Anhänger, am Straßenverkehr teilnehmen zu dürfen, muss der Anhänger mit einer vorschriftsmäßigen Beleuchtung ausgestattet sein. Daher weisen Fahrzeuganhänger ein elektrisches Bordnetz auf, in welches verschiedene Leuchten angeschlossen sind. Üblicherweise sind eine rechte und eine linke Rückleuchte, ein rechter und ein linker Fahrtrichtungsanzeiger, Bremsleuchten vorgeschrieben, zusätzlich können eine Rückfahrleuchte und eine Nebelschlussleuchte verbaut sein. Die verschiedenen Leuchten müssen vom Zugfahrzeug aus gesteuert werden können. Das wird in der Regel dadurch erreicht, dass jede Leuchte des Anhängers über eine eigene Leitung mit einem Steuergerät im Zugfahrzeug verbunden wird. Die Bremsleuchten sind über eine gemeinsame Leitung mit dem Steuergerät verbunden. Diese Leitungen sind über eine Steckverbindung zwischen dem Zugfahrzeug und dem Anhänger geführt. Auf der Seite des Zugfahrzeugs ist als Teil der Steckverbindung die Anhängeranschlussdose vorgesehen, die mit einem Stecker als Teil der Steckverbindung auf der Seite des Anhängers zusammenwirkt. Sowohl in der Anhängeranschlussdose als auch in dem Stecker sind Kontakte vorgesehen, über die die Abschnitte der Leitungen zwischen Steuergerät und Anschlussdose einerseits und zwischen Stecker und Leuchten andererseits verbunden werden können.

Eine bei der Anmelderin bekannte Vorrichtung zur Überwachung einer Anhängeranschlussdose der eingangs genannten Art umfasst mehrere Schaltungen, die auf die folgende Art und Weise gestaltet sind:
Jede Schaltung weist
- einen ersten Anschluss zur Verbindung mit einem positiven Potential einer Spannung eines Bordnetzes des Fahrzeugs,
- einen zweiten Anschluss zur Verbindung mit einem Kontakt der Anhängeranschlussdose,
- einen Messwiderstand, der zwischen dem ersten und dem zweiten Kontakt angeordnet ist
- einen ersten Spannungssensor und einen ersten Spannungsteiler, die zur Messung der Spannung auf einer ersten Seite des Messwiderstands eingerichtet sind,
- einen zweiten Spannungssensor und einen zweiten Spannungsteiler, die zur Messung der Spannung auf einer zweiten Seite des Messwiderstands eingerichtet sind und
- mit einem steuerbaren Schalter in Reihe zu dem Messwiderstand.

Diese Schaltungen der der Anmelderin bekannten Vorrichtung sind einerseits mit dem positiven Potential einer Spannung eines Bordnetzes des Fahrzeugs und andererseits mit einem Kontakt der Anhängeranschlussdose verbunden. Da bei modernen PKW-Anhängern maximal sieben Leuchten des Anhängers vorhanden sind (die Bremsleuchten werden in diesem Zusammenhang als eine Leuchte gezählt, da sie über eine gemeinsame Leitung mit dem Steuergerät im Zugfahrzeug verbunden sind), müssen auch wenigstens sieben Kontakte in der Anschlussdose vorhanden sein. Diese sieben Kontakte der Anschlussdose müssen / können überwacht werden, weshalb in der der Anmelderin bekannten Vorrichtung bis zu sieben Schaltungen der vorgenannten Art vorhanden sind. Bei älteren Anhängermodellen kann durch ein Adapter die vom Fahrzeug zur Verfügung gestellte 13-Polige Anhängersteckdose (nach DIN) auf einen 7-Poligen Anschluss (nach DIN) reduziert werden, bei dem nicht alle sieben Lichtkanäle unterstützt werden. In diesem Fall werden die nicht überprüfbaren Lichtkanäle als nicht vorhanden erkannt.

Auch wenn für die Erkennung ob ein Anhänger an das Zugfahrzeug angehängt bzw. ob ein Anhänger elektrisch mit dem Zugfahrzeug verbunden ist nur die Messung auf vier Leitungen bzw. an vier Kontakten nötig sein sollte, sind für die Anhängererkennung nur noch vier der vorgenannten Schaltungen notwendig. Eine Überwachung aller Leuchten ist bei einer Vorrichtung mit vier Schaltungen der vorgenannten Art allerdings nicht möglich.

Wegen der hohen Anzahl insbesondere auch von aktiven Bauelementen sind die der Anmelderin bekannten Vorrichten sehr aufwendig. Außerdem sind die Messungen in einer Schaltung mit zwei Spannungssensoren zeitaufwendig und erfordern einen hohen Rechenaufwand bei der Auswertung der Messungen. Durch die große Zahl der Bauteile, die für die Messungen benötigt werden, steigen auch die Messfehler. Diese können noch durch Temperaturdrift und Alterungsprozesse negativ beeinflusst werden. Abweichungen durch Analog-Digital-Wandlungen tragen ebenfalls zur Messwertverfälschung bei.

Aus dem Dokument US 3 103 808 ist ferner eine Vorrichtung bekannt, die eine Schaltung umfasst mit den Merkmalen des Oberbegriffs des Anspruchs 1. Diese Vorrichtung ist auf einem Wagen montiert, der zu Testzwecken mit einer Anhängeranschlussdose eines Anhängers verbunden werden kann, um die elektrische Einrichtung des Anhängers zu überprüfen. Auch eine in dem Dokument DE 199 50 851 A1 beschriebenen Vorrichtung weist die eingangs genannten Merkmale des Anspruchs 1 auf.

Die bekannten Vorrichtungen umfassen eine Schaltung
- mit einem ersten Anschluss zur Verbindung mit einem positiven Potential einer Spannung eines Bordnetzes des Fahrzeugs,
- mit zweiten Anschlüssen zur Verbindung mit Kontakten der Anhängeranschlussdose,
- mit einem Strom- und/oder Spannungssensor,
- mit ersten steuerbaren Schaltern, die in Reihe zu je einem der zweiten Anschlüsse liegen,
- wobei jeder der zweiten Anschlüsse in einem geschlossenen Zustand des in Reihe zu dem zweiten Anschluss liegenden ersten Schalter über diesen ersten Schalter mit einem ersten Knoten verbunden ist und
- wobei der erste Knoten über den Strom- und/oder Spannungssensor mit dem ersten Anschluss verbunden ist.

Weder die aus dem einen Dokument bekannte Vorrichtung noch die aus dem anderen Dokument bekannte Vorrichtung weist eine Möglichkeit auf den Sensor der Vorrichtung zu kalibrieren oder eine Plausibilitätsüberprüfung der Funktion der Schaltung durchzuführen.

Der Erfindung lag daher die Aufgabe zugrunde eine Vorrichtung und ein Verfahren zur Überwachung einer Anhängeranschlussdose eines Zugfahrzeugs vorzuschlagen, welche der der Anmelderin bekannten Vorrichtung und der aus dem Dokument US 3 103 808 bekannten Vorrichtung überlegen ist bzw. welches einem mit diesen Vorrichtungen durchführbaren Verfahren überlegen ist.

Die Aufgabe wird im Hinblick auf die Vorrichtung dadurch gelöst, dass der erste Knoten der Schaltung einer erfindungsgemäßen Vorrichtung über einen dritten steuerbaren Schalter mit einem dritten Anschluss zur Verbindung mit einem Massepotential eines Bordnetzes verbunden ist. In Reihe zu dem dritten Schalter ist ein Widerstand angeordnet. Dieser Widerstand ist ein Referenzwiderstand. Der Referenzwiderstand kann über bei geöffneten ersten Schaltern und geschlossenem dritten Schalter einen Referenzstrom führen, der von dem Strom- und/oder Spannungssensor erfasst wird, um eine Kalibrierung des Sensors oder eine Plausibilitätsüberprüfung der Funktion der Schaltung durchzuführen.

Bei der erfindungsgemäßen Vorrichtung ist es ausreichend, wenn eine Schaltung mit den vorgenannten Merkmalen vorhanden ist. Mit einer solchen Schaltung, die nur einen Sensor aufweist, kann je nach Stellung der ersten Schalter die Erkennung durchgeführt werden, ob ein Anhänger angehängt bzw. elektrisch an das Zugfahrzeug angeschlossen ist, oder ob die Leuchten in dem Anhänger einen Strom führen können, der zum ordnungsgemäßen Betrieb der Leuchten notwendig ist. Ferner ist eine Kalibrierung und/oder eine Plausibilitätsüberprüfung der Funktion der Schaltung möglich.

Die Schaltung einer erfindungsgemäßen Vorrichtung kann einen zweiten steuerbaren Schalter aufweisen, der in Reihe zu dem Strom- und/oder Spannungssensor und dem ersten Anschluss angeordnet ist. Mit diesem zweiten Schalter kann die Schaltung aktiviert werden oder in einen Bereitschaftszustand versetzt werden, in dem keine Messungen möglich sind. Im Bereitschaftszustand kann ein Stromverbrauch in der Schaltung verhindert oder zumindest gegenüber einem aktiven Zustand der Schaltung, in welchem Messungen möglich sind, reduziert werden.

Die Schaltung kann in Reihe zu dem Strom- und/oder Spannungssensor, dem ersten Anschluss und ggf. dem zweiten Schalter eine Diode aufweisen. Diese Diode bildet einen einfachen Schutz gegen einen falschen Anschluss der Vorrichtung an ein Bordnetz (Verpolschutzdiode).

Die erfindungsgemäße Vorrichtung weist vorteilhaft eine Steuerung auf, welche mit Steueranschlüssen der ersten Schalter und ggf. des zweiten und/oder des dritten Schalters verbunden sind. Durch die Ansteuerung des zweiten Schalters durch die Steuerung kann die Schaltung aus dem Bereitschaftszustand in den aktiven Zustand überführt werden und umgekehrt, wobei im aktiven Zustand der Schaltung mit dem Strom und/oder Spannungssensor Messungen durchführbar sind. Mittels der Steuerung können ein erster Schalter oder Gruppen von ersten Schaltern zum Schließen angesteuert werden.

Bei einem erfindungsgemäßen Verfahren zur Überwachung einer Anhängeranschlussdose mit einer vorgenannten erfindungsgemäßen Vorrichtung können zu definierende Gruppen von ersten Schaltern geschlossen werden, um zu prüfen, ob ein Bordnetz eines Fahrzeuganhängers an die Anschlussdose angeschlossen ist. Bei diesen Schaltern kann es sich zum Beispiel um die ersten Schalter handeln, über die Ströme zu den Fahrtrichtungsanzeigern und den Schlussleuchten fließen. Die Summe dieser Ströme fließt dann auch über den Strom- und/oder Spannungssensor der Schaltung. Ist der Summenstrom größer als eine vorgegebene Schwelle von zum Beispiel 40 mA, wird ein Anhänger als angehängt bzw. elektrisch angeschlossen erkannt. Ist der Summenstrom dagegen kleiner als die vorgegebene Schwelle, wird der Anhänger nicht erkannt.

Durch ein sequentielles Schließen der ersten Schalter kann geprüft werden, ob an dem in Reihe zu dem geschlossenen Schalter liegenden zweiten Anschluss eine stromführende Last angeschlossen ist, insbesondere ob eine funktionsfähige Leuchte vorhanden ist. Wird vom Strom- und/oder Spannungssensor ein Strom erfasst, der über einem Schwellwert liegt, wird davon ausgegangen, dass die angeschlossene Leuchte des Anhängers einwandfrei funktioniert. Anderenfalls kann der Ausfall der Leuchte angezeigt werden.

Der Strom- und/oder Spannungssensor kann ein integrierter Schaltkreis sein. Es ist möglich, dass der Schaltkreis einen Messwiderstand umfasst. Es ist ebenso möglich, Es ist ebenso möglich, dass der Messwiderstand ein separates Bauelement ist, das mit dem integrierten Schaltkreis verbunden ist.

Eine erfindungsgemäße Vorrichtung kann eine Auswerteeinheit umfassen, in welcher das von dem Strom- und/oder Spannungssensor gelieferte Messsignal ausgewertet wird. Die Auswerteeinheit kann ein Mikrocontroller sein. Im Vergleich zu der der Anmelderin bislang bekannten Technik kann die Auswerteeinheit einfacher ausgestattet sein, da nur das Signal eines Sensors ausgewertet werden muss.

Im Vergleich zu der der Anmelderin vorbekannten Technik kann der für die Schaltung erforderliche Bauraum reduziert werden. Auch kann die erfindungsgemäße Vorrichtung mit größerer Genauigkeit erkennen, ob ein Anhänger angehängt ist oder nicht, was wie der reduzierte Bauraum unmittelbar von der Anzahl der verwendeten Bauelemente abhängt.

Anhand der beigefügten Zeichnungen wird die Erfindung nachfolgend näher erläutert. Dabei zeigt:

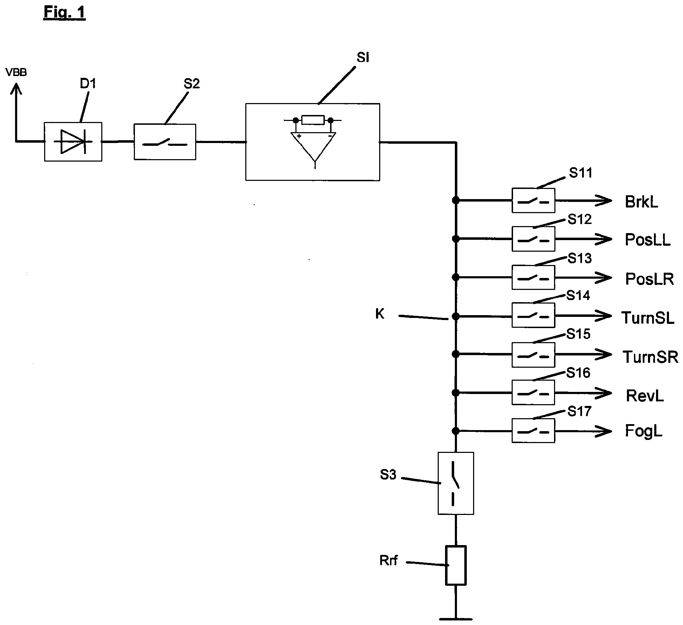

- Fig. 1: ein vereinfachtes Schaltbild einer Schaltung einer erfindungsgemäßen Vorrichtung und
- Fig. 2: ein vereinfachtes Flussdiagramm eines Verfahrens zur Anhängererkennung

Die Schaltung einer erfindungsgemäßen Vorrichtung weist einen ersten Anschluss VBB auf. Dieser ist bei einer in einem Fahrzeug eingebauten Vorrichtung mit dem positiven Potential der Bordnetzspannung verbunden. Bei Kraftfahrzeugen liegt dies meist an der als Klemme 30 bezeichneten Batterie-/Generatorklemme an.

Mit dem ersten Anschluss ist die Kathode einer Verpolschutzdiode D1 verbunden, deren Anode mit einem zweiten Schalter S2 verbunden ist. Der zweite Schalter S2 ist vorzugsweise von einer nicht dargestellten Steuerung der Vorrichtung steuerbar.

In Reihe zu der Diode D1 und dem zweiten Schalter S2 ist ein Stromsensor SI angeordnet. Genauer gesagt weist der Stromsensor SI einen Messwiderstand auf, der in Reihe zu der Diode D1 und dem zweiten Schalter S2 liegt. Neben dem Messwiderstand weist der Stromsensor einen integrierten Schaltkreis auf, welcher den Strom durch den Messwiderstand erfasst und in ein den Strom anzeigendes Signal wandelt.

Auf der dem zweiten Schalter S2 abgewandten Seite ist der Stromsensor SI an einem ersten Knoten K mit sieben ersten Schaltern S11, ..., S17 und einem dritten Schalter S3 verbunden. Die ersten Schalter S11, ... , S17 sind zwischen den ersten Knoten und zweiten Anschlüssen BrkL, PosLL, PosLR, TurnSL, TurnSR, RevL, FogL angeordnet. Die zweiten Anschlüsse dienen der Verbindung der Schaltung mit Kontakten einer Anschlussdose des Kraftfahrzeugs. Es dient im einzelnen der Anschluss BrkL zur Verbindung mit einem Kontakt der Anschlussdose zur Verbindung mit Bremslichtern des Anhängers, der Anschluss PosLL zur Verbindung mit einem Kontakt zur Verbindung mit einer linken Schlussleuchte, der Anschluss PosLR zur Verbindung mit einem Kontakt zur Verbindung mit einer rechten Schlussleuchte, der Anschluss TurnSL zur Verbindung mit einem Kontakt zur Verbindung mit einem linken Fahrtrichtungsanzeiger, der Anschluss TurnSR zur Verbindung mit einem Kontakt zur Verbindung mit einem rechten Fahrtrichtungsanzeiger, der Anschluss RevL zur Verbindung mit einem Kontakt zur Verbindung mit einer Rückfahrleuchte und der Anschluss FogL zur Verbindung mit einem Kontakt zur Verbindung mit einer Nebelschlussleuchte.

Ist der zweite Schalter S2 geschlossen und einer der ersten Schalter S11, ... , S17 geschlossen, kann über diesen ersten Schalter S11, ... , S17 ein Strom zu der mit diesem ersten Schalter S11, ... , S17 verbundenen Leuchte des angehängten Anhängers fließen. Sind mehrere erste Schalter S11, ... , S17 geschlossen, kann zu allen mit den geschlossenen ersten Schaltern S11, ... , S17 verbundenen Leuchten eines angehängten Anhängers ein Strom fließen. Der Strom zu dem oder den Schaltern kann mittels des Stromsensors SI gemessen werden.

Der erste Knoten ist über den dritten Schalter S3 und einem dazu in Reihe geschalteten Referenzwiderstand Rrf mit einem dritten Anschluss verbunden, der im Betrieb der Vorrichtung mit dem Massepotential des Kraftfahrzeugbordnetzes verbunden ist. Ist der zweite und der dritte Schalter S2, S3 geschlossen und sind gleichzeitig alle ersten Schalter S11, ... , S17 geöffnet, fließt ein Strom über den Referenzwiderstand Rrf nach Masse. Dieser Strom kann zur Kalibrierung und zur Prüfung der Funktionsfähigkeit der erfindungsgemäßen Vorrichtung vom Stromsensor SI gemessen werden.

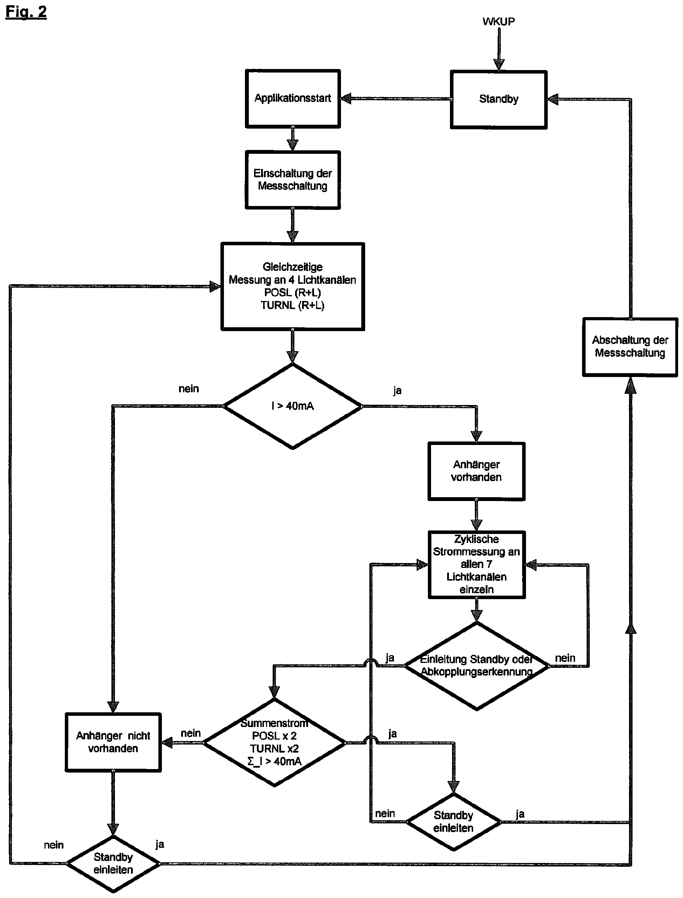

Das Prüfen, ob ein Anhänger an dem Zugfahrzeug angehängt ist oder nicht, kann zum Beispiel gemäß dem in Fig. 2 skizzierten Verfahren stattfinden.

Befindet sich die Schaltung in einem Bereitschaftszustand (Standby), wird zunächst durch ein Signal WKUP von einem externen Steuergerät die Steuerung der Vorrichtung aktiviert. Dann wird von der Steuerung eine Schaltung aktiviert (Applikationsstart), wozu der zweite Schalter, der im Bereitschaftszustand geöffnet ist, geschlossen wird. Durch das Schließen des zweiten Schalters wird die Schaltung (in Fig. 2 als Messschaltung bezeichnet) eingeschaltet. Dann werden durch die Steuerung die ersten Schalter S12, S13, S14, S15 geschlossen, während die übrigen ersten Schalter S11, S16, S17 und der dritten Schalter S3 in einem geöffneten Zustand bleiben. Dann kann ein Strom über den zweiten Schalter S2, den Stromsensor SI zum ersten Knoten K fließen, der sich dann aufteilt und über die geschlossenen ersten Schalter S12, S13, S14, S15 und die Anschlüsse PosLL, PosLR, TurnSL, TurnSR zur rechten und linken Schlussleuchte und zum rechten und linken Fahrtrichtungsanzeiger fließt. Der durch den Stromsensor fließende Strom wird gemessen und in einer Auswerteeinheit mit einem Schwellwert von z.B. 40 mA verglichen. Ist der Strom kleiner als die definierte Schwelle von z.B. 40 mA ist kein Anhänger vorhanden. Die Schaltung kann dann im aktivierten Zustand verbleiben oder in den Bereitschaftszustand zurück versetzt werden.

Wird dagegen der Schwellwert überschritten, wird erkannt, dass ein Anhänger vorhanden ist.

Dann kann eine zyklische Strommessung stattfinden, für die sequentiell alle ersten Schalter S11, ... , S17 geschlossen werden, um zu prüfen ob die an die zweiten Anschlüsse BrkL, PosLL, PosLR, TurnSL, TurnSR, RevL, FogL angeschlossenen Leuchten des Anhängers einen Strom führen können, der für den Betrieb der Leuchten hinreichend ist. Ist die zyklische Überprüfung abgeschlossen worden, wird geprüft, ob der Standby eingeleitet werden oder bei erkannten fehlenden Lichtausgängen (z.B. Defekt einer Leuchte) eine Abkopplungserkennung durchgeführt werden soll. Liegt diese Anforderung vor, wird geprüft, ob der Anhänger vorhanden ist, dass heißt ob der Strom, der über die geschlossenen ersten Schalter S12, S13, S14, S15 und die Anschlüsse PosLL, PosLR, TurnSL, TurnSR zur rechten und linken Schlussleuchte und zum rechten und linken Fahrtrichtungsanzeiger fließt, größer ist als der Schwellwert von 40 mA. Ist das der Fall, wird geprüft, ob die Schaltung in den Bereitschaftszustand versetzt werden soll. Ist das der Fall, wird die Schaltung in den Bereitschaftszustand versetzt, wozu der zweiten Schalter geöffnet wird. Soll kein Bereitschaftszustand eingenommen werden wird die zyklische Strommessung wiederholt.

### Bezugszeichenliste

- VBB: erster Anschluss
- BrkL: Anschluss zur Verbindung mit dem Kontakt der Anschlussdose zur Verbindung mit den Bremsleuchten
- PosLL: Anschluss zur Verbindung mit dem Kontakt der Anschlussdose zur Verbindung mit der linken Schlussleuchte
- PosLR: Anschluss zur Verbindung mit dem Kontakt der Anschlussdose zur Verbindung mit der rechten Schlussleuchte
- TurnSL: Anschluss zur Verbindung mit dem Kontakt der Anschlussdose zur Verbindung mit dem linken Fahrtrichtungsanzeiger
- TurnSR: Anschluss zur Verbindung mit dem Kontakt der Anschlussdose zur Verbindung mit dem rechten Fahrtrichtungsanzeiger
- RevL: Anschluss zur Verbindung mit dem Kontakt der Anschlussdose zur Verbindung mit der Rückfahrleuchte
- FogL: Anschluss zur Verbindung mit dem Kontakt der Anschlussdose zur Verbindung mit der Nebelschlussleuchte
- D1: Verpolschutzdiode
- S11: erster Schalter zum Schalten eines Stromkreises über die Bremsleuchten
- S12: erster Schalter zum Schalten eines Stromkreises über die linke Schlussleuchte
- S13: erster Schalter zum Schalten eines Stromkreises über die rechte Schlussleuchte
- S14: erster Schalter zum Schalten eines Stromkreises über den linken Fahrtrichtungsanzeiger
- S15: erster Schalter zum Schalten eines Stromkreises über den rechten Fahrtrichtungsanzeiger
- S16: erster Schalter zum Schalten eines Stromkreises über die Rückfahrleuchte
- S17: erster Schalter zum Schalten eines Stromkreises über die Nebelschlussleuchte
- S2: zweiter Schalter
- S3: dritter Schalter
- SI: Stromsensor
- K: erster Knoten
- Rrf: Referenzwiderstand

## Patentansprüche

1. Vorrichtung zur Überwachung einer Anhängeranschlussdose eines Fahrzeugs, an welcher das Bordnetz eines Fahrzeuganhängers anschließbar ist, umfassend eine Schaltung
- mit einem ersten Anschluss (VBB) zur Verbindung mit einem positiven Potential einer Spannung eines Bordnetzes des Fahrzeugs,
- mit zweiten Anschlüssen (BrkL, PosLL, PosLR, TurnSL, TurnSR, RevL, FogL) zur Verbindung mit Kontakten der Anhängeranschlussdose,
- mit einem Strom- und/oder Spannungssensor (SI),
- mit ersten steuerbaren Schaltern (S11, ... , S17), die in Reihe zu je einem der zweiten Anschlüsse (BrkL, PosLL, PosLR, TurnSL, TurnSR, RevL, FogL) liegen,
- wobei jeder der zweiten Anschlüsse (BrkL, PosLL, PosLR, TurnSL, TurnSR, RevL, FogL) in einem geschlossenen Zustand des in Reihe zu dem zweiten Anschluss (BrkL, PosLL, PosLR, TurnSL, TurnSR, RevL, FogL) liegenden ersten Schalter (S11, ... , S17) über diesen ersten Schalter (S11, ... , S17) mit einem ersten Knoten (K) verbunden ist und
- wobei der erste Knoten (K) über den Strom- und/oder Spannungssensor (SI) mit dem ersten Anschluss (VBB) verbunden ist,
**dadurch gekennzeichnet,**
- **dass** der erste Knoten (K) über einen dritten steuerbaren Schalter (S3) und einen zu dem dritten Schalter (S3) in Reihe geschalteten Referenzwiderstand (Rrf) mit einem dritten Anschluss zur Verbindung mit einem Massepotential eines Bordnetzes verbindbar ist und
- **dass** bei geöffneten ersten Schaltern (S11, ..., S17) und geschlossenem dritten Schalter (S3) ein Strompfad zwischen dem ersten Anschluss (VBB) und dem dritten Anschluss über den ersten Knoten und den Referenzwiderstand (Rrf) hergestellt ist, über den ein Strom zur Kalibrierung des Strom- und/oder Spannungssensors (SI) und zur Prüfung der Funktionsfähigkeit der Schaltung fließen kann, der von dem Strom- und/oder Spannungssensor (SI) messbar ist.

2. Vorrichtung nach Anspruch 1, **dadurch gekennzeichnet, dass** die Schaltung einen zweiten steuerbaren Schalter (S2) aufweist, der in Reihe zu dem Strom- und/oder Spannungssensor (SI) und dem ersten Anschluss (VBB) angeordnet ist.

3. Vorrichtung nach Anspruch 1 oder 2, **dadurch gekennzeichnet, dass** die Schaltung eine Diode (D1) in Reihe zu dem Strom- und/oder Spannungssensor (SI), dem ersten Anschluss (VBB) und ggf. dem zweiten Schalter (S2) aufweist.

4. Vorrichtung nach einem der Ansprüche 1 bis 3, **dadurch gekennzeichnet, dass** die Vorrichtung eine Steuerung aufweist, welche mit Steueranschlüssen der ersten Schalter (S11-S17) und ggf. des zweiten und/oder des dritten Schalters (S2, S3) verbunden ist.

5. Vorrichtung nach Anspruch 4, **dadurch gekennzeichnet, dass** mittels des zweiten Schalters (S2) die Schaltung aus einem Bereitschaftszustand in einen aktiven Zustand überführbar ist und umgekehrt, wobei im aktiven Zustand der Schaltung mit dem Strom und/oder Spannungssensor (SI) Messungen durchführbar sind.

6. Vorrichtung nach Anspruch 4 oder 5, **dadurch gekennzeichnet, dass** mittels der Steuerung ein erster Schalter oder Gruppen von ersten Schaltern zum Schließen ansteuerbar sind.

7. Verfahren zur Überwachung einer Anhängeranschlussdose mit einer Vorrichtung nach einem der Ansprüche 1 bis 6, **gekennzeichnet durch** ein Schließen einer Gruppe von ersten Schaltern (S11, ... , S17), um zu prüfen, ob ein Bordnetz eines Fahrzeuganhängers an die Anschlussdose angeschlossen ist.

8. Verfahren nach Anspruch 7 **gekennzeichnet durch** ein sequentielles Schließen der ersten Schalter (S11, ... , S17), um zu prüfen, ob an dem in Reihe zu dem geschlossenen ersten Schalter (S11, ... , S17) liegenden zweiten Anschluss (BrkL, PosLL, PosLR, TurnSL, TurnSR, RevL, FogL) eine stromführende Last angeschlossen ist.

## Claims

1. Device for monitoring a trailer connector socket of a vehicle at which the electrical system of a vehicle trailer can be connected, comprising a circuit
- with a first connection (VBB) for connecting to a positive potential of a vehicle electrical system voltage,
- with two connections (BrkL, PosLL, PosLR, TurnSL, TurnSR, RevL, FogL) for connecting to contacts of the trailer connector socket,
- with a current and/or voltage sensor (SI),
- with first controllable switches (S11-S17) each of which are in series to one of the two connections (BrkL, PosLL, PosLR, TurnSL, TurnSR, RevL, FogL),
- where each of the two connections (BrkL, PosLL, PosLR, TurnSL, TurnSR, RevL, FogL) is connected via said first switch (S11-S17) with a first node (K), the first switch (S11-S17) connected in series to the second connection (BrkL, PosLL, PosLR, TurnSL, TurnSR, RevL, FogL) being in a closed state and
- where the first node (K) is connected to the first connection (VBB) via the current and/or voltage sensor (SI),
**characterized in that**
- the first node (K) can be connected via a third controllable switch (S3) and a reference resistor (Rrf) wired in series to a third switch (S3) to a third connection for connecting to a ground potential pf a vehicle electrical system and
- when the first switches (S11-S17) are open and the third switch (S3) is closed a current path is created between the first connection (VBB) and the third connection via the first node and the reference resistor (Rrf) through which a current for calibrating the current and/or voltage sensor (SI) and for testing the proper functioning of the circuit can flow which can be measured by the current and/or voltage sensor (SI).

2. Device in accordance with Claim 1, **characterized in that** the circuit features a second controllable switch (S2) that is arranged in series to the current and/or voltage sensor (SI) and the first connection (VBB).

3. Device in accordance with Claim 1 or 2 **characterized in that** the circuit features a diode (D1) that is arranged in series to the current and/or voltage sensor (SI), the first connection (VBB) and, as applicable, the second switch (S2).

4. Device in accordance with one of Claims 1 through 3, **characterized in that** the device features a control system that is connected via control connections to the first switch (S11-S17) and, as applicable, the second and/or the third switch (S2, S3).

5. Device in accordance with Claim 4, **characterized in that** the circuit can be transferred by means of the second switch (S2) from a stand-by state into an active state and vice versa, where measurements can be performed with the current and/or voltage sensor (SI) when the circuit is in an active state.

6. Device in accordance with Claim 4 or 5, **characterized in that** the control system can be used to trigger a first switch or groups of first switches to close.

7. Procedure for monitoring a trailer connector socket with a device in accordance with one of Claims 1 through 6, **characterized by** the closing of a group of switches (S11-S17) to check whether an electrical system of a vehicle trailer is connected to the connector socket.

8. Procedure in accordance with Claim 7 **characterized by** sequential closing of the first switches (S11-S17) to check whether a current carrying load is connected to the second connection (BrkL, PosLL, PosLR, TurnSL, TurnSR, RevL, FogL) connected in series to the closed first switch (S11-S17).

## Revendications

1. Dispositif de surveillance d'une boîte de jonction de remorque d'un véhicule auquel peut être raccordé le réseau de bord d'une remorque de véhicule, comprenant un circuit
- avec un raccordement primaire (VBB) pour la liaison avec un potentiel positif d'une tension d'un réseau de bord du véhicule,
- avec des raccordements secondaires (BrkL, PosLL, PosLR, TurnSL, TurnSR, RevL, FogL) pour la liaison avec des contacts de la boîte de jonction de la remorque,
- avec un capteur de courant et/ou de tension (SI),
- avec des commutateurs pilotables primaires (S11, ..., S17), raccordés chacun en série avec l'un des raccordements secondaires (BrkL, PosLL, PosLR, TurnSL, TurnSR, RevL, FogL),
- sachant que chacun des raccordements secondaires (BrkL, PosLL, PosLR, TurnSL, TurnSR, RevL, FogL) est raccordé, à l'état fermé du commutateur primaire (S11, ..., S17) relié en série au raccordement secondaire (BrkL, PosLL, PosLR, TurnSL, TurnSR, RevL, FogL), avec un premier nœud (K) par l'intermédiaire de ce commutateur primaire (S11, ..., S17) et
- que le premier nœud (K) est connecté au raccordement primaire (VBB) via le capteur de courant et/ou de tension (SI),
**caractérisé en ce que**
- le premier nœud (K) peut être relié, par l'intermédiaire d'un troisième commutateur pilotable (S3) et d'une résistance de référence (Rrf) connectée en série avec le troisième commutateur (S3), à un troisième raccordement pour assurer la liaison avec un potentiel de masse d'un réseau de bord et
- **en ce que**, lorsque les interrupteurs primaires (S11, ..., S17) sont ouverts et que le troisième interrupteur (S3) est fermé, un trajet de courant est établi entre le raccordement primaire (VBB) et le troisième raccordement par l'intermédiaire du premier nœud et de la résistance de référence (Rrf), trajet par lequel un courant peut circuler pour calibrer le capteur de courant et/ou de tension (S1) et pour vérifier le bon fonctionnement du circuit, ce courant pouvant être mesuré par le capteur de courant et/ou de tension (SI).

2. Dispositif selon la revendication 1, **caractérisé en ce que** le circuit comporte un commutateur secondaire pilotable (S2) monté en série avec le capteur de courant et/ou de tension (SI) et le raccordement primaire (VBB).

3. Dispositif selon la revendication 1 ou 2, **caractérisé en ce que** le circuit comprend une diode (D1) en série avec le capteur de courant et/ou de tension (SI), le raccordement primaire (VBB) et, le cas échéant, le commutateur secondaire (S2).

4. Dispositif selon l'une des revendications 1 à 3, **caractérisé en ce que** le dispositif comporte une commande reliée à des raccordements de commande des commutateurs primaires (S11 -S17) et, éventuellement, du commutateur secondaire et/ou du troisième commutateur (S2, S3).

5. Dispositif selon la revendication 4, **caractérisé en ce qu'**au moyen du commutateur secondaire (S2), le circuit peut passer d'un état d'attente à un état actif et inversement, des mesures pouvant être effectuées avec le capteur de courant et/ou de tension (SI) dans l'état actif du circuit.

6. Dispositif selon la revendication 4 ou 5, **caractérisé en ce qu'**un commutateur primaire ou des groupes de commutateurs primaires peuvent être commandés pour la fermeture au moyen de la commande.

7. Procédé de surveillance d'une boîte de jonction de remorque avec un dispositif selon l'une des revendications 1 à 6, **caractérisé par** une fermeture d'un groupe de commutateurs primaires (S11, ..., S17) pour vérifier si un réseau de bord d'une remorque de véhicule est connecté à la boîte de jonction.

8. Procédé selon la revendication 7 **caractérisé par** une fermeture séquentielle des interrupteurs primaires (S11, ..., S17) pour vérifier si une charge sous tension est connectée au raccordement secondaire (BrkL, PosLL, PosLR, TurnSL, TurnSR, RevL, FogL) monté en série avec le commutateur primaire (S11, ..., S17) fermé.
